# EUROPEAN PATENT APPLICATION

(11) **EP 0 762 559 A2**
(43) Date of publication of application: **12.03.1997**
(21) Application number: 96113507.6
(22) Date of filing: 22.08.1996
(51) Int. Cl.: H01R 23/70

(54) **Electric connector terminal having a round soldering tail**

(30) Priority: 24.08.1995 JP 9811/95
(71) Applicant: MOLEX INCORPORATED, Lisle Illinois 60532 (US)
(72) Inventor: Watanabe, Yoshinori, Sagamihara-shi, Kanagawa (JP); Ikesugi, Hiroshi, Yokohama-shi, Kanagawa (JP)
(74) Representative: Blumbach, Kramer & Partner

(57) **Abstract**

An electric connector terminal (4) has a soldering tail (7) for soldering to a selected pad (13) on a printed circuit member. The electric connector terminal (4) is formed of a stamped metal piece comprising a contact section (3) and a housing engagement section (5) for receipt into a connector opening (2) and engagement therewith. At least one of such sections is of substantially rectangular shape in cross-section. The electric connector terminal (4) also includes intermediate and tail sections (6,7) which are coined to a substantially circular or elliptical cross-sectional shape to minimize short circuits and maximize soldering reliability. A method of manufacturing such terminal and a connector including a plurality of such terminals are also disclosed.

## Description

### Background of the Invention:

The present invention relates to an electric connector terminal of stamped metal to be soldered to a selected pad on a printed circuit, and a method of forming such terminal.

A conventional surface mount terminal is typically formed of a stamped metal piece comprising tip and housing engagement sections and intermediate and tail sections integrally connected to and bent relative to the tip and housing engagement sections. The tip and housing engagement sections of the terminal are typically inserted in a selected receiving opening in a surface mount connector housing, and the housing engagement section is caught or latched by opposite walls around the opening, thus preventing the terminal from slipping out of the opening while permitting its tip section to function as a contact in the connector housing. The intermediate and tail sections are exposed and extend from the connector housing, so that the tail section can be soldered to a selected pad on a printed circuit board. A plurality of stamped terminals are typically formed in parallel and quite close to each other. As formed, they are connected with a carrier strip, and these stamped terminals typically are cut, or otherwise separated, from the carrier strip after they are inserted in the openings of the connector housing.

In some applications, after separation from the carrier strip, the intermediate and tail sections extend straight from the tip and housing engagement sections of the stamped terminals, and it is necessary that the intermediate and tail sections be bent relative to the tip and housing engagement sections so as to permit the solder tails of the stamped terminals to be aligned with and contact the selected pads of a printed circuit board to which they are to be soldered when the electric connector housing is surface mounted on the printed circuit. Alternatively, the intermediate and tail sections may be bent relative to the tip and housing engagement sections of the terminals prior to insertion into the connector housing.

Each stamped terminal typically has a rectangular cross-section over its full length or at least the intermediate and tail sections. The rectangular cross-section of the intermediate and tail sections of the stamped terminal causes several problems. A first problem is that the reliability of the solder bond may be diminished due to insufficient space for a good solder fillet between the exterior surfaces of the solder tail of the terminal and the selected pad on the printed circuit board. A second problem is that the separation between adjacent solder tails may be so small, e.g., frequently on the order 0.5 mm or less between tail centers, that electric discharges may occur between a pad and an adjacent solder tail. In addition, shorting may occur between adjacent tails and pads due to bridging of the relatively liquid solder and flux between two terminals and/or pads. Such shorting or bridging may be further aggravated where a solder tail deviates from the correct alignment relative to its respective pad even though such deviation remains within the range of manufacturing tolerance. In fact, such misalignment is almost inevitable.

A third problem is that due to manufacturing tolerances, the intermediate and tail sections of the stamped terminals will also usually not have an exact rectangular shape in cross-section. Since the upper and/or lower surfaces thereof are used for bending or forming the intermediate and tail sections, the intermediate and tail sections will not bend in a straight line. As a result of this, the solder tail on the end of the tail section may deform when bent, thereby causing the solder tail to not be coplanar with the remaining length of the stamped terminal. The loss of coplanarity may result in the misalignment of the solder tail of the stamped terminal relative to the selected pad on a printed circuit board as described above, which can result in undesirable electric discharges or shorting between adjacent terminals.

### Summary of the Invention:

One object of the present invention is to provide a stamped and formed terminal for use in a surface mount connector in which coplanarity of the solder tail and the remaining length of the terminal are substantially assured, in which the fillet space is large enough to assure reliable soldering between the solder tail and the selected pad on a printed circuit board, and in which the possibility of undesirable bridging and electrical discharges are minimized between closely spaced adjacent tails and/or pads.

To attain this object, an electric connector terminal is provided having a solder tail which, when exposed from the electric connector housing, can be soldered to a selected pad on a printed circuit board, and wherein the electric connector terminal is a stamped and formed metal member comprising a contact section, a housing engagement section and intermediate and tail sections integrally connected to and bent relative to the contact and housing engagement sections. A portion of the terminal has a substantially rectangular shape in cross-section, but at least the tail section thereof has a substantially curved shape in cross-section on at least the side of which is to be soldered to a pad on the circuit board which advantageously increases the spacing between the solder tails and the printed circuit board circuit pads.

In still another principal aspect of the invention, a method of forming an electric terminal having a solder tail for soldering to a selected pad on a printed circuit board includes the steps of stamping the terminal from a flat stock of electrically conductive material to form the terminal into a contact section, a housing engagement section and a tail section, with each having a substantially rectangular cross-section with substantially flat faces thereon; and forming the flat face on at least one side of the tail section of the terminal into a substantially curved shape in cross-section.

In still another principal aspect of the invention, the substantially curved shape is either substantially circular or elliptical in cross-section.

In still another principal aspect of the invention, the substantially curved shape is formed by coining.

These and other objects, features and advantages of the present invention will be clearly understood through a consideration of the following detailed description.

### Brief Description of the Drawings:

In the course of this description, reference will frequently be made to the attached drawings in which:
FIG. 1 is a perspective view of a surface mount electrical connector terminal having a solder tail and constructed according to a preferred embodiment of the present invention;
FIG. 2 is a plan view of a carrier strip holding a plurality of the terminals of FIG. 1;
FIG. 3 is a side elevational view of the carrier strip and electric connector terminal of FIG. 2;
FIG. 4 is an enlarged cross-sectional view of the solder tail being reshaped with a coining die in accordance with the present invention and showing burrs projecting from opposite sides of the tail;
FIG. 5 is an enlarged cross-sectional view of the reshaped solder tail shown in FIG. 4, but from which the burrs have been cut and removed;
FIG. 6 is an enlarged cross-sectional rear elevational view through adjacent solder tails of the present invention in place within a surface mount connector wherein the solder tails have deviated slightly from their correct positions, but are soldered to the pads of a printed circuit board;
FIG. 7 is an enlarged cross-sectional rear elevational view of a solder tail of the present invention in place within a surface mount connector which is in proper alignment with and is soldered to a pad of a printed circuit board;
FIG. 8 is an enlarged cross-sectional view of another embodiment of shape of solder tail which has been reshaped with a coining die, and in which the burrs have been removed; and
FIG. 9 is an enlarged cross-sectional view of the reshaped solder tail of FIG. 8, but from which the burrs have removed to leave flat sides.

### Description of the Preferred Embodiment:

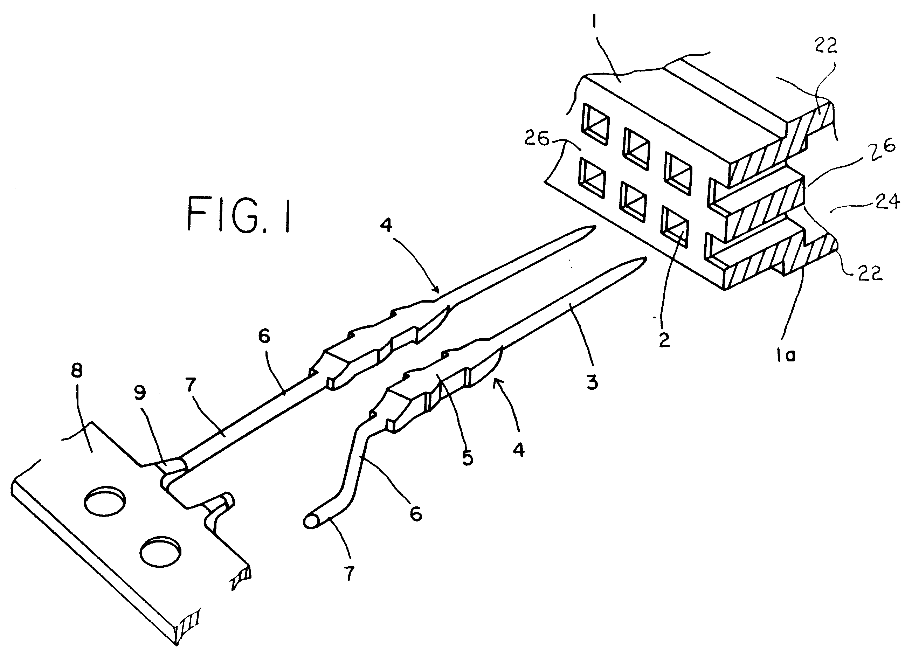

Referring particularly to FIGS. 1 to 3 of the drawings, an electric connector terminal 4 constructed in accordance with the principles of the present invention includes a solder tail 7 to be soldered to a selected conductive pad on a printed circuit board. The connector terminal 4 comprises a stamped metal piece which is stamped from a flat sheet of electrically conductive metal. The connector terminal 4 includes a tip or contact section 3, a connector housing engagement section 5, and respective intermediate and tail sections 6 and 7 integrally connected to, and bent relative to the tip section 3 and engagement section 5. The tip section 3 and engagement section 5 of the terminal 4 are inserted in a selected terminal-receiving opening 2 of a connector housing 1 until the engagement section 5 of the male terminal 4 is latched or otherwise secured by the opposite sides of the opening 2.

In this position, the intermediate and tail sections 6 and 7 extend from the connector housing 1 with the solder tail 7 being generally coplanar with the bottom 1a of the connector housing 1. The intermediate and tail sections 6 and 7 may be bent relative to the remaining length of the terminal 4 as shown in the rightmost terminal 4 of FIG. 1 either before or after the insertion of the terminal 4 in the selected hole 2 of the connector housing 1. The bent solder tail 7 is thereby adapted to be soldered to the pads 13 of a printed circuit board 20 as will be described in more detail to follow, and when so soldered, will typically surface mount the connector housing 1 to the surface of a circuit board 20.

The connector housing 1 is of known construction of an insulating material such as plastic and has sidewalls 22 surrounding a connector component-receiving slot 24 therebetween which receives a portion of a complementary mating connector component (not shown). The connector housing 1 shown in FIG. 1 has its terminal-receiving openings 2 extending between endwalls 26 of the housing 1 as opposed to in the sidewalls 22 thereof.

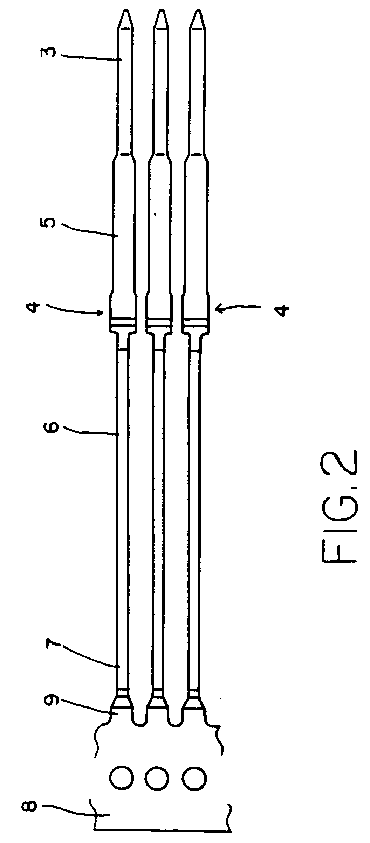

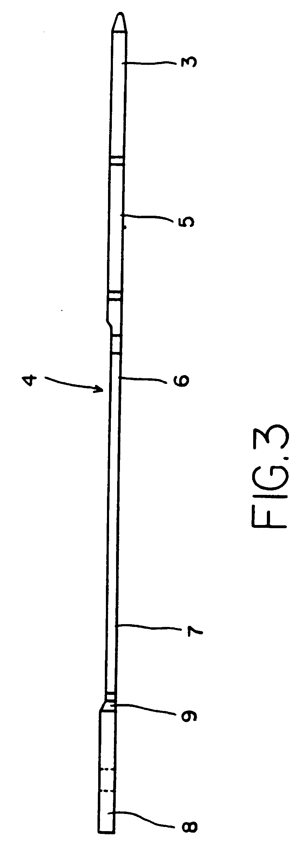

In the present invention, the tip section 3 and engagement section 5 of the male terminal 4 have a substantially rectangular shape in cross-section, and the intermediate and tail sections 6 and 7 of the male terminal 4 have a substantially circular shape in cross-section. However, as initially formed, a plurality of terminals 4 are arranged in parallel to each other and connected to a carrier strip 8. The terminals 4 are typically stamped out of the flat sheet metal material and, as such, each terminal 4 typically will have a rectangular shape in cross-section with flat faces over its full length immediately after stamping as shown in FIGS. 2 and 3. The term "rectangular cross-section" as used herein is intended to refer to non-curved cross-sections, such as, for example, square and rectangular cross-sections.

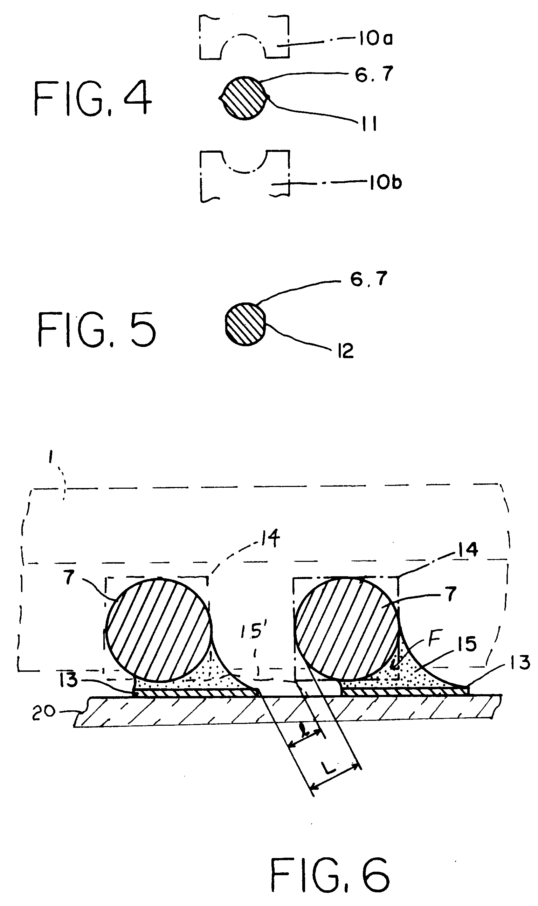

Referring now to FIG. 4, the initially rectangular intermediate and tail sections 6 and 7 of each terminal 4 are coined between die pieces 10a and 10b, as shown in phantom, to change their rectangular cross-section and form them into a curved cross-section. As shown in FIG. 4, the curved cross-section is generally circular and the curved intermediate and tail sections 6 and 7 may have burrs 11 on their opposite sides following coining. When such burrs 11 occur, they are cut off therefrom and removed. Removal of the burrs may also be extended, if desired, to form flat surfaces 12 on the opposite sides of the round intermediate and tail sections 6 and 7, as seen in FIG. 5.

The portions of the terminal 4 having a curved cross-section over intermediate and tail sections 6 and 7 are substantially free of distortion when bent relative to the tip section 3 and housing engagement section 5 of the male terminal 4. This permits the intermediate and tail sections 6 and 7 as thus bent, to be coplanar with the remaining sections 3 and 5 of the male terminal 4. This coplanarity improves the alignment of the solder tail 7 with a selected pad 13 of a printed circuit board 20.

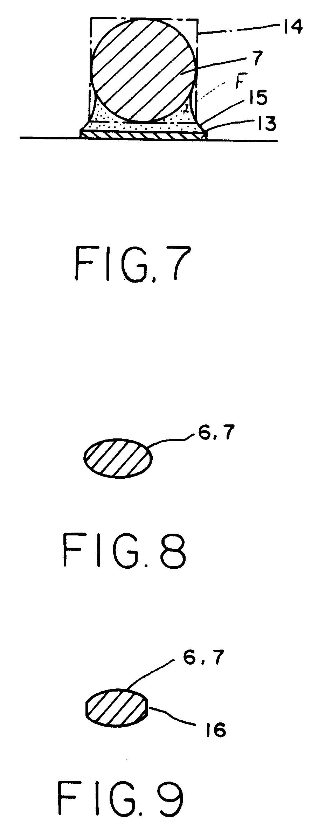

Referring now to FIGS. 6 and 7, a rear view of a portion of a surface mount connector housing 1 is shown in phantom mounted to a printed circuit board 20. A plurality of terminals 4 are disposed in the connector housing 1 and the solder tail portions 7 thereof extend therefrom so they may be received upon conductive pads 13 formed on the printed circuit board 20. The curved cross-sectional shape on the side of the solder tail 7 of terminals of the present invention which are to be soldered to the printed circuit board pads 13 importantly has the effect of increasing the fillet space F available between the solder tail 7 and the pad 13, thereby improving the reliability of the solder joint of the terminal 4 to pad 13 of the printed circuit board 20. Also, the circular cross-section of the curved solder tail 7 has the advantage of increasing the distance "**L**" between the closest point of the curved tail 7 and an adjacent pad 13. More specifically, as shown in FIG. 6, the center of curved solder tail 7 is shown as being somewhat displaced from the center of pad 13, whereas in FIG. 7, the curved solder tail 7 is shown in its correct alignment relative to the pad 13.

In FIGS. 6 and 7, a rectangular solder tail 14 having a square cross-section 14 is shown in phantom. From this it will be appreciated that the curved cross-section 7 provides a fillet space F which is larger than that available in the square cross-section 14, accordingly increasing the fillet of solder 15 to improve the reliability of the solder joint. Also, as seen in FIG. 6, it can be seen that when the curved solder tail 7 deviates from its correct alignment from the pad 13 so that it is positioned closer to an adjacent pad 13, a relatively long distance "**L**" between them still remains. This can easily be seen by comparing the distance "**l**" which would otherwise exist between pad 13 and a square solder tail 14. Thus, the possibility of undesirable electric discharges between adjacent pads and terminals is minimized.

Still further, during the placement of the connector 1 onto the printed circuit board 20 and also during the soldering of the solder tail 7 to the pad 13, the solder and flux may be in either a soft or relatively liquid state. Accordingly, for a given amount of solder and flux, the square cross-section 14 may tend to displace this flowable solder and flux toward the next adjacent square cross-sectioned tail 14. This displacement can be of a sufficient magnitude, particularly where the tails may have center-to-center spacings as small as 0.5 mm and less, and may result in the solder 15 being pushed sideways toward an adjacent square cross section solder tail 14. Additionally, when the solder 15 is liquified during the soldering process, a solder bridge 15' may occur as shown in FIG. 6 in phantom, which will cause an undesired short circuit. However, where the tails 7 are of curved cross-section as in the present invention, the solder and flux which might otherwise be so displaced to form the undesirable bridge are instead more likely to be used to advantage in the greater fillet space F. It can be seen in FIG. 6 that the increased distance "**L**" between the pads 13 and adjacent terminals 7 decreases the likelihood of such bridging from occurring.

As seen in FIGS. 8 and 9, the curved shape of the intermediate and tail sections 6 and 7 also may be other similar shapes such as substantially elliptical shape in cross-section, with the longer axis of the ellipse being parallel to the printed circuit board to which it will be mounted. In this case, an elliptical coining die is used to reshape the intermediate and tail sections 6 and 7 of the otherwise rectangular stamped terminal 4. Again, should burrs occur, they may be cut and removed from the opposite sides, as seen in FIGS. 8 and 9. Additional amounts may be cut and removed to define flat surfaces 16 on the opposite sides of the tail section 7 as shown in FIG. 9. As is the case with the circular solder tail as described above, the elliptical solder tail also provides a fillet space which is significantly increased compared with the square solder tail, thereby permitting the use of an increased amount of solder to assure reliable soldering, and it also minimizes bridging of the solder as previously described. Also, when the elliptical tail is displaced from its correct alignment relative to the pad, the elliptical solder tail is spaced further from an adjacent conductor compared with the spacing between a square solder tail and an adjacent pad, thus minimizing the possibility of undesirable electric discharges or bridging between them.

It will be appreciated that although the curved in cross-section solder tails which have been shown and described above as defining a substantially full circle or ellipse in cross-section, other shapes are considered to be within the term "curved" as employed herein. Some of these other cross-sectional shapes include the curved shapes as shown in FIGS. 5 and 9 in which the sides of the tail 7 are slightly flattened during burr removal. The term "curved" is also intended to cover other non-square and non-rectangular cross-sectional shapes such as polygonal shapes having a sufficiently large number of faces to approach a purely rounded circular cross-section, e.g., a hexagon or decagon.

It will also be appreciated that tails having cross-sectional shapes such as semicircles or semiellipses might also be within some of the principles of the present invention. One of the important aspects of the invention is the elimination of the squared corners on the side of the tail which is to be soldered to the pad 13 in order to maximize the fillet F and minimize the possibility of a bridging flow of solder 15' as shown in FIG. 6. Accordingly, it will be appreciated that the upper side of the tail opposite the side which is to be soldered to the pad need not necessarily have the curved shape in order to achieve the last mentioned advantages. However, if a flat surface is utilized for bending, the advantage for coplanarity will be lost.

It will also be understood that the embodiments of the present invention which have been described are illustrative of some of the applications of the principles of the present invention. Various modifications may be made by those skilled in the art without departing from the true spirit and scope of the invention.

## Claims

1. In a surface mount electrical connector (1) for mounting to a printed circuit member (20), the connector (1) having a housing (1a), with a plurality of terminal receiving cavities (24), a plurality of stamped and formed terminals (4) disposed in the connector housing (1a), each terminal (4) having a contact portion (3) for engaging a complementary mating component, a body portion (5) disposed within one of said terminal receiving cavities and a solder tail portion (7) extending from said housing (1a) for soldering to one of a plurality of conductive pads (13) disposed on said printed circuit board (20), said terminal contact and body portions (3,5) having generally rectangular cross-sections, characterized in that:
said solder tail portions (7) having a cross-section different from that of said body and contact portions (3,5), said solder tail portions (7) each having at least one substantially curved surface as part of their respective cross-sections, the curved surface being disposed thereon to be positioned in opposition to said printed circuit member pads (13).

2. The electrical connector of claim 1, wherein said solder tail portions (7) are circular in cross-section.

3. The electrical connector of claim 1, wherein said solder tail portions (7) are elliptical in cross-section.

4. The electrical connector of claim 3, wherein said elliptical solder tail portions (7) have major and minor axes, the major axes extending horizontally with respect to said printed circuit member pads.

5. The electrical connector of claim 1, wherein said solder tail portion cross-sections (7) include slightly flattened portions (12, 16) on at least one side other than said curved surfaces.

6. The electrical connector of claim 1, wherein said curved surfaces are formed by coining.

7. The electrical connector terminal of claim 1, wherein said terminals further include intermediate portions (6) interconnecting said solder tail and body (7,5) portions, said intermediate and solder tail portions (6,7) both sharing said different cross-sections and both further having said substantially curved surfaces disposed thereon.

8. The electrical connector of claim 7, wherein both of said solder tail and intermediate portions (6,7) are circular in cross-section.

9. The electrical connector of claim 7, wherein said solder tail and intermediate portions (6,7) are elliptical in cross-section.

10. The electrical connector of claim 7, wherein said solder tail portions (7) have widths which are no greater than widths of said printed circuit member pads (13).

11. The electrical connector of claim 7, wherein said substantially curved surfaces are formed by coining.

12. A method of forming an electric terminal (4) having a solder tail (7) for soldering to a selected pad (13) on a printed circuit member, comprising the steps of:
stamping the terminal (4) from a flat stock (8) of electrically conductive material to form the terminal (4) into a contact section (3), a housing engagement section (5) and a solder tail section (7), and at least some of said sections having a substantially rectangular cross-section with substantially flat faces thereon; and
forming at least one side of the solder tail section (7) of the terminal (4) into a substantially curved shape in cross-section.

13. The method of claim 12, wherein said substantially curved shape is circular in cross-section.

14. The method of claim 12, wherein said substantially curved shape is elliptical in cross-section.

15. The method of claim 14, wherein the longer axis of the ellipse is parallel to a bottom side of the rectangular tip and engagement sections.

16. The method of claim 12, wherein said substantially curved shape in cross-section is slightly flattened on at least one side other than the side with the curved shape in cross-section.

17. The method of claim 12, wherein said substantially curved shape in cross-section is formed by coining.

18. The method of claim 17, wherein said substantially curved shape is circular in cross-section.

19. The method of claim 19, wherein said substantially curved shape is elliptical in cross-section.

20. The method of claim 19, wherein the longer axis of the ellipse is parallel to the bottom side of the rectangular contact and housing engagement sections.

21. The method of claim 17, wherein said substantially curved shape in cross-section is slightly flattened on at least one side other than the side with the curved shape in cross-section.

22. The method of claim 12, wherein all of said sections are initially stamped to be substantially rectangular in cross-section with substantially flat faces thereon, and thereafter said curved shape is formed on at least one flat face of said solder tail section (7).

23. The method of claim 22, wherein said curved shape is formed by coining.

24. An improved terminal for use in a surface mount electrical connector (30) of the type which is mounted on and soldered to a printed circuit board (20), the connector (30) having an insulative housing with a plurality of terminal receiving passages, the terminal (4) comprising:
a contact portion (3) for engaging a complementary component, a connector housing engagement portion (5) for securing a portion of the terminal within one of said terminal-receiving passages, at least one of said contact portion and said housing engagement portion having a generally rectangular cross-section, and a solder tail portion (7) which extends from said connector housing engagement portion for positioning in opposition to a contact pad (13) disposed on said printed circuit board (20), the solder tail portion (7) having a curved contact surface in opposition to the circuit board contact pad (13), the curved contact surface of said solder tail portion (7) being adapted to be received adjacent said circuit board contact pad (13) when said connector is mounted on said printed circuit board (20), said curved contact surface defining fillet spaces (F) between said solder tail portion (7) and said circuit board contact pad (13).

25. The connector terminal as set forth in claim 24, wherein said solder tail portion (7) has a generally circular cross-section.

26. The connector terminal as set forth in claim 24, wherein said solder tail portion (7) has a generally elliptical cross-section.
